# EUROPEAN PATENT SPECIFICATION

(11) **EP 0 302 290 B1**
(45) Date of publication and mention of the grant of the patent: **14.12.1994**
(21) Application number: 88111521.6
(22) Date of filing: 18.07.1988
(51) Int. Cl.: H04N 5/50

(54) **Automatic frequency control system**
Automatisches Frequenzregelssystem
Système de contrôle automatique de fréquence

(30) Priority: 03.08.1987 US 81041; 03.08.1987 US 81085; 03.08.1987 US 80934
(43) Date of publication of application: 08.02.1989
(73) Proprietor: MOTOROLA INC., Schaumburg Illinois 60196 (US)
(72) Inventor: McGinn, Michael, Scottsdale Arizona 85257 (US)
(74) Representative: Hudson, Peter David

(56) References cited:
- DE-A- 3 036 351
- DE-B- 2 651 297
- US-A- 4 358 791
- US-A- 4 575 761

## Description

### BACKGROUND OF THE INVENTION

The present invention relates to automatic frequency control (AFC) circuits and, more particularly, to a high gain phase locked loop (PLL) AFC system suited to be utilized in combination with a high performance television receiver.

In a typical television receiver AFC system the intermediate frequency (IF) signal is first limited to remove amplitude modulation therefrom and then supplied to a frequency discriminator circuit. A tuned circuit and a multiplier are required to convert a frequency deviation of the IF signal from its nominal frequency into a change in voltage at the output of the multiplier. This voltage is then applied to the local oscillator (LO) in the tuner section of the television receiver to, in turn, cause a resultant change in the IF signal as understood. The tuned circuit and multiplier form a phase detector. Thus, a change in the IF signal from the nominal center frequency of the tuned circuit produces a change in phase from the initial ninety degrees between the two inputs to the double balanced multiplier. This change in phase is therefore the reason a change in the drive voltage to the LO is produced.

The typical AFC system described above has several serious disadvantages associated therewith. First, the tuned circuit has to be adjusted and is in fact a source of radiation that can cause instability in the IF signal detection. Secondly, due to the characteristics of the IF bandpass filter, the AFC loop characteristics are asymmetrical. One of the effects of this asymmetry is that system noise will add a direct current component to any direct current offsets in the loop and, hence, is one of the factors limiting the direct current loop gain. Low loop gain in turn leads to large frequency errors at the input tuner which limits system acquisition which is highly undesirable. Finally, the coil of the tuned circuit is expensive and must be adjusted which is also undesirable.

Additionally, systems such as those known from US-A-4,575,761 and DE-A-2,651,297, which comprise an AFC loop and a PLL loop, are susceptible to interference between said AFC loop and said PLL loop in the event that an IF signal is absent since in this case both said loops operate independently at different frequencies.

### SUMMARY OF THE INVENTION

Accordingly, present invention seeks to provide an improved automatic frequency control circuit for use in a television receiver in which these disadvantages are overcome or at least alleviated.

In accordance with the above and other objects there is provided an automatic frequency control circuit as claimed in claim 1. This circuit controls said AFC loop and said PLL as well in the event of an absence of said IF signal in such a manner that said LO and said VCO are both clamped to the same frequency.

### BRIEF DESCRIPTION OF THE DRAWINGS

Fig. 1 is a partial block and schematic diagram illustrating the automatic frequency control system of the present invention;
Fig. 2 is a waveform illustrating the bandpass characteristics of the IF filter of the system of Fig. 1;
Fig. 3 is a partial block and schematic diagram of the acquisition circuit of the embodiment of Fig. 1.
Fig. 4 is a schematic diagram illustrating a phase shift circuit utilised in the control systems of Fig. 1; and
Fig. 5 is a vector diagram useful for understanding the circuit of Fig. 4.

### DETAILED DESCRIPTION OF A PREFERRED EMBODIMENT

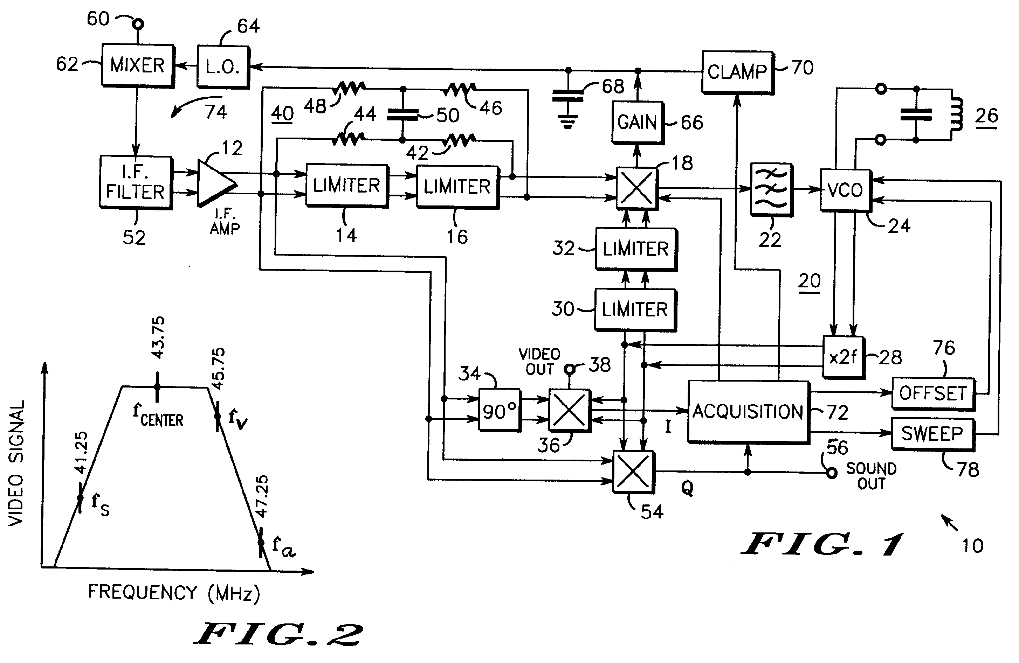

Turning now to Fig. 1 there is shown the improved automatic frequency control (AFC) loop of the present invention in combination with the video demodulator circuit 10.

Briefly, video demodulator circuit 10 provides the video information signal at output 38 of balanced demodulator 36. Video demodulator circuit 10 includes IF amplifier 12 to which the IF television signal is applied and which has outputs coupled both to limiter stage 14 and ninety degree phase shift circuit 34. The amplitude modulation is removed from the IF signal by series connected limiter stages 14 and 16 and applied to the inputs of quadrature phase detector 18. Video demodulator circuit 10 comprises phase locked loop (PLL) 20 including detector 18, low pass filter 22 which is coupled between detector 20 and voltage controlled oscillator 24, tuned circuit 26, times 2 frequency multiplier circuit 28 which is coupled between VCO 24 and series connected limiter stages 30 and 32. The balance outputs of limiter stage 32 are coupled to additional inputs of detector 18. Balanced demodulator 36 has inputs to which outputs of phase shift circuit 34 and frequency multiplier circuit 28 are applied. Feedback is provided by feedback circuit 40 between the outputs of limiter stage 16 to the inputs of limiter stage 14. Feedback circuit 40 comprises resistors 42, 44, 46 and 48 as well as capacitor 50.

As understood, as long as the frequency of the IF signal applied to IF amplifier 12 from IF filter 52 is within the acquisition and lock up range of PLL 20 the video carrier signal will be demodulated to provide the video information signal at output 38 of demodulator 36. Similarly, the IF signal from IF amplifier 12 is also applied in phase quadrature with respect to demodulator 36 to the inputs of balanced demodulator 54. In combination with the inputs from times 2 frequency multiplier 28 demodulator 54 produces the sound information signal at output 56.

Turning now to Fig. 2 the bandpass characteristic of IF filter 52 are briefly described. In the United States the nominal center frequency of filter 52 is set at 43.75 MHZ. Both the video, fᵥ, and sound, fₛ, signals occur at 45.75 MHz and 41.25 MHz respectively which frequencies are out of the passband of the filter. Moreover, the adjacent television channel sound signal, fₐ, appears at a frequency of 47.25 MHz.

The television composite signal is applied from the RF section (not shown) to input terminal 60 to mixer section 62. In general, local oscillator (LO) 64 is operated at the IF signal frequency and produces in conjunction with mixer 60 the IF signal that is applied to the input of filter 52. In most prior art television receivers LO 64 and mixer 62 comprise part of an AFC loop for maintaining IF frequency lock. These prior art AFC loops require in addition a separate tuned circuit tuned to the video signal frequency, i.e., 45.75 MHz.

As will be described in detail, the AFC loop of the present invention does not require a separate tuned circuit thereby eliminating the need for a relative expensive inductor that requires tuning in production. Eliminating the tuned coil also eliminates radiation problems associated with most prior art television receivers.

The AFC loop of the present invention utilizes error output signals generated at the output of phase detector 18 of PLL 20 to control the oscillation frequency of LO 64 to achieve automatic frequency control. AFC loop 74 of the present invention includes gain stage 66 coupled between outputs of phase detector 18 and LO 64 for providing control voltage across capacitor 68 to the control input of the oscillator. Moreover, the AFC loop including clamp circuit 70 is controlled by acquisition circuit 72 in conjunction with PLL 20 to provide symmetrical pull in and acquisition of the IF signal.

Acquisition circuit 72 is responsive to the quadrature related output signals from demodulators 36 and 54 to provide the control functions for sensing (1) no signal and (2) out of lock conditions in order to provide the symmetrical pull in and acquisition of the IF signal.

Provided that the gain around the loop comprising LO 64 is much greater than the gain of PLL 20, VCO 24 will act as the reference frequency of the AFC system of the present invention.

As mentioned above, acquisition circuit 72 is responsive to the quadrature related video and sound signals produced from demodulators 36 and 54 for providing control output signals that are utilized to control the operating frequency of VCO 24 via offset circuit 76 and sweep circuit 78. Also, acquisition circuit 72 provides enabling and disabling control of both phase detector 18 and clamp circuit 70 as will be described.

In operation, if there is no television signal applied to input 60, the in phase (I) and quadrature (Q) output signals from demodulators 36 and 54 will be absent. This condition is sensed by acquisition circuit 72. In response, offset circuit 76 is enabled to provide an offset voltage to the control input of VCO 24. The operating frequency of VCO 24 is then driven from its nominal frequency of 45.75 MHz to the center bandpass frequency 43.75 MHz of IF filter 52. Simultaneously, acquisition circuit 72 enables clamp circuit 70 which produces a predetermined voltage across capacitor 68 to the input of LO 64. This causes the nominal operating frequency to be changed to the center bandpass frequency of IF filter 52, the same as VCO 24. Thus, under no signal conditions, both AFC loop 74 and the VCO loop of the receiver are set to the same frequency corresponding to the center frequency of filter 52. Hence, any drift of LO 64 or VCO 24 occurs about the center frequency of filter 52.

Now, when a signal appears, because both LO 64 and VCO 24 are operating at 43.75 MHZ, the IF section will be out of lock. In this condition, beat note frequencies are produced between demodulators 36 and 54 corresponding to the I and Q output signals applied to acquisition circuit 72.

As long as the beat notes are present, indicating an out of lock condition, acquisition circuit 72 will provide a control signal to sweep circuit 78 which, in turn, causes the frequency of VCO 24 to be swept from the initial offset frequency downward to a frequency of 41.75 MHZ. Hence, at the first occurrence of the beat note frequencies, the frequency of VCO 24 is initially pulled downward. Once the lower frequency is reached VCO 24 is allowed to sweep upwards towards the video carrier frequency of 45.75 MHZ. Simultaneously with VCO 24 being swept downwards phase detector 18 is disabled by acquisition circuit 72. This prevents PLL 20 from locking to the sound carrier signal fₛ. Once VCO 24 begins sweeping upward in frequency phase detector 18 is again enabled which permits PLL to lock when the frequency of VCO 24 reaches the video signal frequency. The beat note frequencies will disappear as soon as PLL 20 has achieved phase lock of the IF signal. This condition is sensed by acquisition circuit 72 which inhibits both offset circuit 76 and sweep circuit 78. Control of VCO 24 is then released to permit it to operate at its nominal operating frequency.

Upon the occurrence of lock up, clamp circuit 70 is also disabled to allow LO 64 to be driven such that the IF frequency is returned to its correct value (45.75 MHz). It is noted that the gain of the LO loop is much greater than the gain of the VCO loop, therefore VCO 24 only moves several kilohertz from its locked nominal frequency of 45.75 MHz whereas LO 64 can be moved MHz in frequency to correct IF errors of this magnitude.

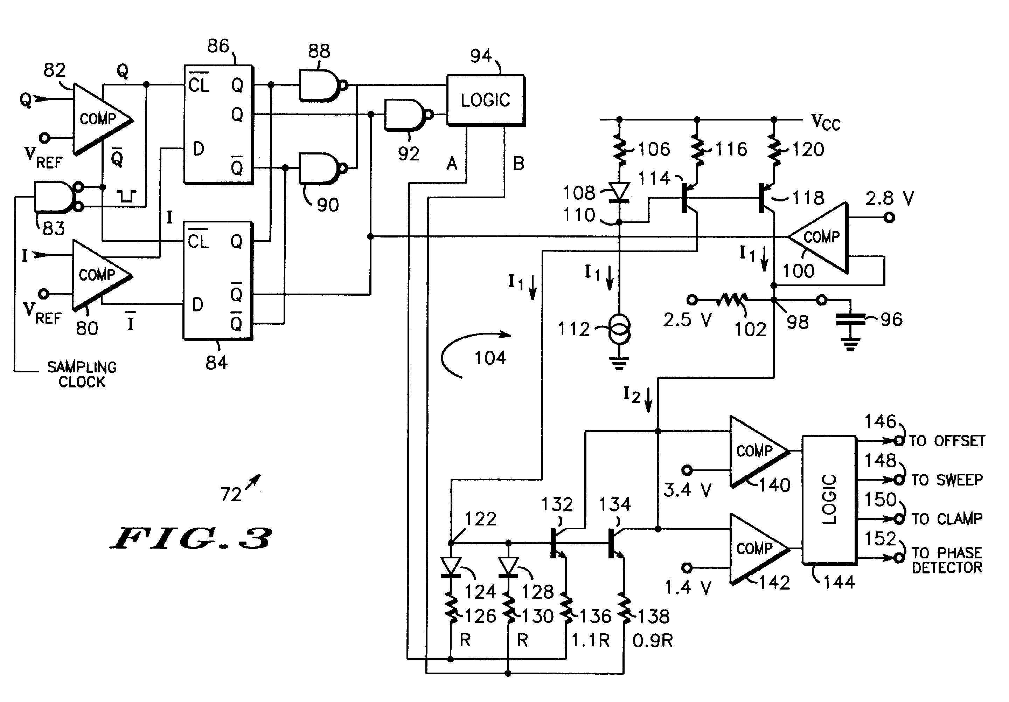

Referring to Fig. 3 the detail and description of the operation of acquisition circuit 72 is more fully explained. The I and Q signals from demodulators 36 and 54 are applied to respective inputs of comparators 80 and 82. The beat note signals are compared with a reference voltage V_{ref} applied at the second input of the two comparators to provide differentials output signals therefrom. The differential output signals from comparator 80 are applied to the respective data input terminals of D flip-flops 84 and 86 while the differential output signals of comparator 82 are respectively applied to the clock input terminals of the two flip-flops. In addition, a sampling clock signal is applied via Nand gate 83 to the clock terminal of the two flip-flops. A Q output of each of the D flip-flops 84 and 86 are connected to the input of Nand gate 88 the output of which is coupled to an input of logic circuit 94. Similarly, a respective Q output of the two D flip-flops or connected to the input of Nand gate 90 the output of which is connected with the output of Nand gate 88 and applied to the first input of logic circuit 94. An additional Q output of D flip-flop 86 is wired connected with an additional Q output of D flip-flop 84 to the input of Nand gate 92 the output of which is connected to a second input of logic circuit 94. Logic circuit 94 provides a pair of logic output signals A and B which are utilized to charge and discharge capacitor 96; the latter of which is coupled between node 98 and ground. Comparator 100 has an output connected to the input of Nand gate 92 and a pair of inputs coupled respectively to node 98 and a reference voltage, for example 2.8 volts. Node 98 is returned via resistor 102 to another reference voltage, for instance 2.5 volts. As illustrated the A and B outputs of logic circuit 94 are directly coupled to lock indicator circuit 104 comprising current sourcing and sinking circuitry. The current sourcing circuit comprises reference current source including resistor 106 series connected with diode 108 between supply voltage V_{cc} and node 110. Current source 112 is coupled between node 110 and ground. Transistors 114 and 118 are biased to source a current I1 as their bases are coupled to node 110. The respective emitters of transistors 114 and 118 are returned to V_{cc} via resistors 116 and 120.

Hence, the current I1 is sourced from the collector of transistor 114 to node 122 which is coupled through series connected resistor 124 and diode 126 to the A output of logic circuit 94. Transistor 118 also sources a current I1 directly to node 98. Series connected resistor 130 and diode 130 are coupled between node 122 and the B output of logic circuit 94. Transistors 132 and 134 provide circuitry for sinking current I2 from node 98 as their respective collectors are connected thereto. The bases of these two transistors are connected to node 122 while their respective emitters are coupled via resistors 136 and 138 to the A and B outputs of logic circuit 94. A pair of threshold comparators 140 and 142 have a first input coupled to node 98 and respective outputs coupled to logic circuit 144. Comparator 140 which has a second input connected to a reference potential, for instance, 3.4 volts provides indication of a lock condition. Comparator 142 which has a second input coupled to a reference potential, for example 1.4 volts provides indication of out of lock signal conditions. Logic circuit 144 is responsive to the output signals for generating the various control signals at outputs 146, 148, 150 and 152 to control the enabling and disabling of offset circuit 76, sweep circuit 78, clamp circuit 70 and phase detector 18 as described above in reference to Fig. 1.

As previously mentioned the purpose of acquisition circuit 72 is to detect the presence or absence of the IF signal and to indicate when VCO 24 is phase locked to the signal. With no IF signal the I and Q outputs of demodulators 36 and 54 will contain only noise. In this condition outputs A and B of logic circuit 94 will switch between 0 and 1 logic states with equal time weighting. Hence, the net charge put on lock indicator capacitor 96 will be zero as current is equally sourced and sunk at node 98. Node 98 will therefor be maintained at 2.5 volts which maintains all of the comparators 100, 140 and 142 in a non-operative condition, all outputs are at a zero logic state.

However, if there is no IF signal but low gain tuner noise outputs A and B may not be switched. If this condition occurs node 98 will then rise in potential until as though PLL 20 is locked until 2.8 volts is reached. At this time the lock test comparator 100 switches output states to remove the inhibit signal at the input of Nand gate 92. If PLL 20 is not locked at this time the input to Nand gate 92 switches to a logic 1 state and the polarity of the A and B outputs of logic circuit 94 are reversed. This causes node 98 to be driven below 2.8 volts which causes an inhibit signal at the output of comparator 100. Comparator 100 will continually provide an inhibit and the enabling output as aforedescribed such that node 98 oscillates about 2.8 volts under these conditions.

If, however, having released or enabling Nand gate 92 the input to Nand gate 92 from D flip flops 84 and 86 is at a logic 0 due to the sampling of the I signal by sample clock circuit 83, the A and B outputs of logic circuit 94 remain unchanged and node 98 will go to 4.3 volts. As the voltage at node 98 exceeds 3.4 volts lock comparator 140 is operated and sweep circuit 78 is disabled as well as clamp circuit 70 by the control signals produce from the respective outputs of logic circuit 144.

When the demodulator circuit is out of lock and beat notes appear from demodulators 36 and 54, flip-flops 80 and 82 are clocked and either the input to Nand gate 88 or Nand gate 90 go to a logic 1. Hence, the output of Nand gate 88 is forced to a logic 0. This causes the A output of logic circuit 94 to become a logic 1 while the B output goes to a logic 0. Thus, I2 becomes greater than I1 and the voltage at node 98 is pulled down to 0.8 volts. However, as the voltage decreases below 1.4 volts beat comparator 142 is operated and the sweep generator is enabled to initiate the acquisition sequence described above.

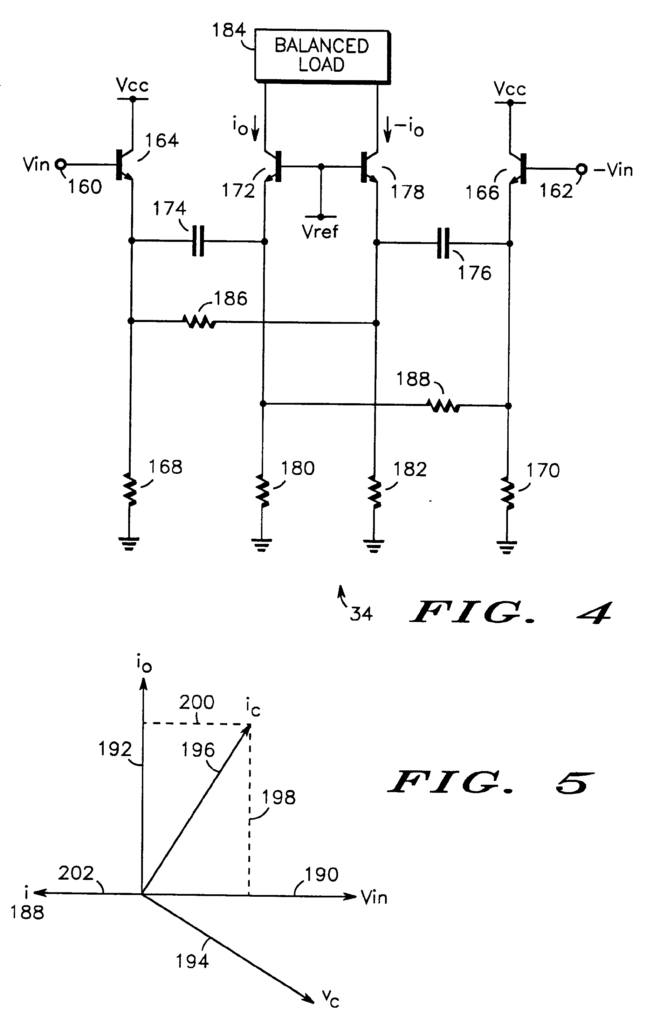

Referring to Figs. 4 and 5 the operation of phase shift circuit 34 of the present invention will now be explained. Phase shift circuit 34 is adapted to receive a differential input voltage Vin corresponding to the outputs of I.F. Amplifier 12) across inputs 160 and 162 to the base electrodes of transistors 164 and 166, the collectors of which are coupled to a first power supply conductor to which is supplied Vcc. The emitters of transistors 164 and 166 are coupled to a second power supply conductor via respective resistors 168 and 170 to which is supplied a ground reference potential. The emitter of transistor 164 is coupled to the emitter of transistor 172 via capacitor 174 while the emitter of transistor 166 is coupled through capacitor 30 to the emitter of transistor 178. Transistor pairs 164, 172 and 161,178 essentially form a pair of differential amplifiers with the bases of transistors 172 and 178 being commonly connected to receive a bias potential Vref. The emitters of transistors 172 and 178 are also respectively coupled to the second power supply conductor via resistors 180 and 182. The collectors of transistors 172 and 178 are differentially coupled to a double balanced load or utilization means 40. Utilization means 184 may, for example, be double balance demodulator circuit 36 (Fig. 1). Adjustable phase control is obtain by the pair of resistors 186 and 188 which are cross coupled between the emitters of transistors 164 and 186, and 166 and 172 respectively.

In operation the differential input voltage Vin is converted to a differential output current iₒ produced at the collectors of transistors 172 and 178. Ideally, with matched transistors, the differential output current iₒ is phase shifted ninety degrees with respect to Vin. Hence, the voltage Vin applied, for instance, to the base of transistor 164 is level shifted and appears at the emitter thereof as illustrated by vector 190, Fig. 5. Vin is converted to the current i_{c} through capacitor 174 to drive transistor 172 to, in turn, produce a the output current iₒ which are ninety degrees with respect to Vin, see vector 192. If the transistors were ideal resistors 186 and 188 would not be required. However, due to the small signal emitter resistances (re) associated with the bipolar transistors a small phase error is introduced which otherwise causes a phase shift to Vin, vector 194, as well as resultant current i_{c}, vector 196, source through capacitor 174 to transistor 32.

As illustrated, the current i_{c} having phase error associated therewith is comprised of both a vertical component, vector 198, and a horizontal component, vector 200. As will be explained, cross-coupled resistors 186 and 188 are used to cancel the horizontal components of the phase error associated with i_{c} and, thus, the differential output currents iₒ and -iₒ. As understood, the differential input voltage applied at input 162 is out of phase with respect to Vin. This produces a current flow through resistor 188 which is out of phase with the horizontal component of iₒ flowing through capacitor 174. By adjusting resistor 188, the magnitude of i₁₈₈ can be adjusted until it, vector 202, cancels the horizontal component of i_{c}. Similarly, resistor 186 cancels the horizontal component of the capacitive current flowing through capacitor 176. Thus, the phase errors due to re are corrected by the cross-coupled resistors whereby the differential output currents iₒ and -iₒ appear in phase quadrature to Vin and -Vin.

## Claims

1. An automatic frequency control circuit (10) for use in a television receiver having a local oscillator (L0) (64), a demodulator section including a pair of quadrature operated demodulators (36,54), a phase locked loop (20) including a phase detector (18) and a voltage controlled oscillator (VCO) for phase locking onto a received IF signal, said automatic frequency control circuit comprising:
a sensing circuit (72) coupled to respective outputs of the demodulators for detecting the absence or presence of the IF signal to provide a plurality of enabling and disabling control signals respectively at respective first and second outputs;
an offset circuit (76) coupled to said first output of said sensing circuit, said offset circuit being enabled by said plurality of enabling control signals in the absence of the IF signal for providing a control signal to the VCO causing the nominal operating frequency thereof to change to a predetermined frequency;
a clamp circuit (70) coupled to said second output of said sensing circuit, said clamp circuit being enabled by said plurality of enabling control signals in the absence of the IF signal for providing a control signal to the LO thereby causing the nominal operating frequency thereof to be changed to substantially said predetermined frequency; and
said sensing circuit (72) providing said plurality of said disabling control signals at said first and second outputs thereof to disable said offset circuit and said clamp circuit in the presence of the IF signal and the phase locked loop becoming phase locked thereto.

2. The automatic frequency control circuit of claim 1 including:
said sensing circuit (72) being responsive to the presence of an IF signal while the phase locked loop is in an out of lock condition for providing an additional enabling signal;
a sweep circuit (78) responsive to said additional enabling signal applied thereto from said sensing circuit for providing a sweep control signal to the VCO which causes the frequency of the VCO to sweep first downward from said predetermined frequency to another predetermined frequency and then to sweep upward to said nominal operating frequency; and
said sensing circuit being responsive to said VCO becoming phase locked to the IF signal for disabling said offset circuit, said sweep circuit and said clamp circuit.

3. The automatic frequency control circuit of claim 2 wherein said sensing circuit (72) provides a disable signal to the phase detector (18) during the time that the VCO is being swept downward in frequency by said sweep circuit.

4. A television receiver circuit including the automatic frequency control circuit of claim 1, 2 or 3 and a demodulator section comprising:
first (14) and second (16) cascoded limiter stages for limiting the amplitude of an input signal applied to said first limiter stage;
the phase locked loop (PLL) (20), which is coupled to the output of said second limiter stage, includes the voltage controlled oscillator (VCO) (24) operated at half the frequency of the input signal, and third (30) and fourth (32) cascoded limiter stages;
a phase shift circuit (34) receiving the input signal for providing a predetermined amount of phase shift thereto; and
the demodulator circuit (36) receiving both said phase shifted input signal and an output signal of said PLL for demodulating the input signal to provide a detected output signal.

5. The television receiver circuit of claim 4 including a direct current (dc) feedback circuit (40) coupled between the output of said second limiter stage and the input of said first limiter stage.

6. The television receiver circuit of claim 5 wherein said PLL includes:
a phase detector circuit (18) coupled to said output of said second limiter stage (16) and the output of said fourth limiter stage (32) for providing an error signal whenever the limited input signal is other than in phase quadrature to the VCO signal;
a low pass filter (22) coupled between said phase detector means and said VCO; and
a multiplier circuit (28) coupled between the output of said VCO and the input of the third limiter stage (30) for doubling the frequency of said VCO signal to provide said output signal of said PLL (20).

7. The television receiver circuit of claim 5 wherein said dc feedback circuit includes:
first (42) and second (44) resistors series coupled between a first output of said second limiter stage (16) and a first input of said first limiter stage (14);
third (46) and fourth (48) series coupled resistors coupled between a second output of said second limiter stage and a second input of said first limiter stage; and
a capacitor (50) coupled between the interconnections of said first and second resistors and said third and fourth resistors.

8. A television receiver circuit of claim 4, 5, 6, or 7 wherein the phase shift circuit (34) comprises:
a first differential amplifier including first (164) and second (172) transistors, the base of said second transistor being biased at a reference potential;
a second differential amplifier including third (166) and fourth (178) transistors, the base of said fourth transistor being biased at said reference potential, the bases of said first and third transistors being coupled to a pair of inputs of the phase shift circuit to which a differential input voltage is supplied;
a first capacitor (174) coupled between the emitters of said first and second transistors;
a second capacitor (176) coupled between the emitters of said third and fourth transistors;
a first resistor (188) coupled between said emitters of said second and fourth transistors;
a second resistor (186) coupled between said emitters of said first and third transistors; and
the collectors of said second and fourth transistors being coupled to a load (184).

## Patentansprüche

1. Automatische Frequenzregelungsschaltung (10) zum Einsatz in einem Fernsehempfänger mit einem Empfangsoszillator (LO) (64), einem Demodulatorabschnitt einschließlich eines Paares in 90°-Phasenverschiebung betriebener Demodulatoren (36, 54), einer Phasenregelschleife (20) einschließlich eines Phasendetektors (18) und eines spannungsgesteuerten Oszillators (VCO) zur Phasenverriegelung auf ein empfangenes IF-Signal, wobei die automatische Frequenzregelungsschaltung umfaßt:
eine Erfassungschaltung (72), die an entsprechende Ausgänge der Demodulatoren geschaltet ist und das Nichtvorhandensein oder Vorhandensein des IF-Signals erfaßt und eine Vielzahl von Freigabe- bzw. Sperr-Steuersignalen an entsprechenden ersten und zweiten Ausgängen erzeugt;
eine Offset-Schaltung (76), die an den ersten Ausgang der Erfassungsschaltung geschaltet ist, wobei die Offset-Sschaltung durch die Vielzahl von Freigabe-Steuersignalen beim Nichtvorhandensein des IF-Signals freigegeben wird und ein Steuersignal an den VCO erzeugt, das bewirkt, daß sich die Nenn-Betriebsfrequenz desselben auf eine vorgegebene Frequenz ändert;
eine Clamping-Schaltung (70), die an den zweiten Ausgang der Erfassungsschaltung geschaltet ist, wobei die Clamping-Schaltung durch die Vielzahl von Freigabe-Steuersignalen beim Nichtvorhandensein des IF-Signals freigegeben wird und ein Steuersignal an den LO erzeugt, wodurch bewirkt wird, daß die Nenn-Betriebsfrequenz desselben auf im wesentlichen die vorgegebene Frequenz verändert wird; und
wobei die Erfassungsschaltung (72) die Vielzahl der Sperr-Steuersignale an den ersten und den zweiten Ausgängen derselben erzeugt, um die Offset-Schaltung und die Clamping-Schaltung beim Vorhandensein des IF-Signals zu sperren, und die Phasenregelschleife darauf phasenverriegelt wird.

2. Automatische Frequenzregelungsschaltung nach Anspruch 1, die einschließt:
daß die Erfassungsschaltung (72) auf das Vorhandensein eines IF-Signals anspricht, während sich die Phasenregelschleife in einem nicht verriegeltem Zustand befindet, und ein zusätzliches Freigabesignal erzeugt;
eine Durchlaufschaltung (78), die auf das zusätzliche Freigabesignal anspricht, das von der Erfassungsschaltung an sie angelegt wird, und ein Durchlauf-Steuersignal an den VCO erzeugt, das bewirkt, daß die Frequenz des VCO's von der vorgegebenen Frequenz zunächst nach unten zu einer weiteren vorgegebenen Frequenz läuft und anschließend zu der Nenn-Betriebsfrequenz nach oben läuft; und
daß die Erfassungsschaltung darauf anspricht, daß der VCO auf das IF-Signal phasenverriegelt wird, und sie die Offset-Schaltung, die Durchlaufschaltung und die Clamping-Schaltung sperrt.

3. Automatische Frequenzregelungsschaltung nach Anspruch 2, wobei die Erfassungsschaltung (72) während der Zeit, in der die Durchlaufschaltung die Frequenz des VCO nach unten laufen läßt, ein Sperrsignal an den Phasendetektor (18) sendet.

4. Fernsehempfängerschaltung einschließlich der automatischen Frequenzregelungsschaltung nach Anspruch 1, 2 oder 3 und eines Demodulatorabschnitts, der umfaßt:
eine erste (14) und eine zweite (16) in Kette geschaltete Begrenzerstufe, die die Amplitude eines Eingangssignals begrenzen, das an die erste Begrenzerstufe angelegt wird;
die Phasenregelschleife (PLL) (20), die an den Ausgang der zweiten Begrenzerstufe geschaltet ist, und die den spannungsgesteuerten Oszillator (VCO) (24) enthält, der bei der Hälfte der Frequenz des Eingangssignals betrieben wird, sowie eine dritte (30) und eine vierte (32) in Kette geschaltete Begrenzerstufe;
eine Phasenschieberschaltung (34), die das Eingangssignal empfängt und einen vorgegebenen Betrag an Phasenverschiebung derselben ausführt; und
die Demodulatorschaltung (36), die sowohl das phasenverschobene Eingangssignal als auch ein Ausgangssignal der PLL empfängt und das Eingangssignal demoduliert, um ein demoduliertes Ausgangssignal zu erzeugen.

5. Fernsehempfängerschaltung nach Anspruch 4, die eine Gleichstrom-Rückkopplungsschaltung (40) enthält, die zwischen den Ausgang der zweiten Begrenzerstufe und dem Eingang der ersten Begrenzerstufe geschaltet ist.

6. Fernsehempfängerschaltung nach Anspruch 5, wobei die PLL enthält:
eine Phasendetektorschaltung (18), die an den Ausgang der zweiten Begrenzerstufe (16) und den Ausgang der vierten Begrenzerstufe (32) geschaltet ist und immer dann ein Fehlersignal erzeugt, wenn das begrenzte Eingangssignal gegenüber dem VCO-Signal nicht um 90° phasenverschoben ist;
ein Tiefpaßfilter (22), das zwischen die Phasendetektoreinrichtung und den VCO geschaltet ist; und
eine Vervielfacherschaltung (28), die zwischen den Ausgang des VCO und den Eingang der dritten Begrenzerstufe (30) geschaltet ist und die Frequenz des VCO-Signals verdoppelt, um das Ausgangssignal der PLL (20) zu erzeugen.

7. Fernsehempfängerschaltung nach Anspruch 5, wobei die Gleichstrom-Rückkopplungsschaltung enthält:
einen ersten (42) und einen zweiten (44) Widerstand, die zwischen einen ersten Ausgang der zweiten Begrenzerstufe (16) und einen ersten Eingang der ersten Begrenzerstufe (14) in Reihe geschaltet sind;
einen dritten (46) und einen vierten (48) in Reihe geschalteten Widerstand, die zwischen einen zweiten Ausgang der zweiten Begrenzerstufe und einen zweiten Eingang der ersten Begrenzerstufe geschaltet sind; und
einen Kondensator (50), der zwischen die Verbindungen des ersten und des zweiten Widerstandes und des dritten und des vierten Widerstandes geschaltet ist.

8. Fernsehempfängerschaltung nach Anspruch 4, 5, 6 oder 7, wobei die Phasenschieberschaltung (34) umfaßt:
einen ersten Differenzverstärker, der einen ersten (164) und einen zweiten (172) Transistor enthält, wobei die Basis des zweiten Transistors auf ein Bezugspotential vorgespannt ist;
einen zweiten Differenzverstärker, der einen dritten (166) und einen vierten (178) Transistor enthält, wobei die Basis des vierten Transistors auf das Bezugspotential vorgespannt ist, wobei die Basen des ersten und des zweiten Transistors an ein Paar von Eingängen der Phasenschieberschaltung geschaltet sind, denen eine Differenzeingangsspannung zugeführt wird;
einen ersten Kondensator (174), der zwischen die Emitter des ersten und des zweiten Transistors geschaltet ist,
einen zweiten Kondensator (176), der zwischen die Emitter des dritten und des vierten Transistors geschaltet ist;
einen ersten Widerstand (188), der zwischen die Emitter des zweiten und des vierten Transistors geschaltet ist;
einen zweiten Widerstand (186), der zwischen die Emitter des ersten und des dritten Transistors geschaltet ist; und
wobei die Kollektoren des zweiten und des vierten Transistors an eine Last (184) geschaltet sind.

## Revendications

1. Circuit de commande automatique de fréquence (10) utilisé dans un récepteur de télévision ayant un oscillateur local (LO)(64), une partie de démodulateur comprenant une paire de démodulateurs fonctionnant en quadrature (36, 54), une boucle de phase asservie (20) comprenant un détecteur de phase (18) et un oscillateur commandé en tension (VCO) pour verrouiller la phase sur un signal FI reçu, ledit circuit de commande automatique de fréquence comprenant :
un circuit de détection (72) couplé aux sorties respectives des démodulateurs pour détecter l'absence ou la présence du signal FI pour fournir une pluralité de signaux de commande de validation et d'invalidation respectivement sur des première et seconde sorties respectives ;
un circuit de décalage (76) couplé à ladite première sortie dudit circuit de détection, ledit circuit de décalage étant validé par ladite pluralité de signaux de commande de validation en l'absence du signal FI pour fournir un signal de commande au VCO entraînant la fréquence de fonctionnement nominale de celui-ci à changer en une fréquence prédéterminée ;
un circuit de verrouillage (70) couplé à ladite seconde sortie dudit circuit de détection, ledit circuit de verrouillage étant validé par ladite pluralité de signaux de commande de validation en l'absence du signal FI pour fournir un signal de commande au LO entraînant ainsi une fréquence de fonctionnement nominale de celui-ci à être changée en essentiellement ladite fréquence prédéterminée ; et
ledit circuit de détection (72) fournissant ladite pluralité desdits signaux de commande d'invalidation sur lesdites première et seconde sorties de celui-ci pour invalider ledit circuit de décalage et ledit circuit de verrouillage en la présence du signal FI et la boucle de phase asservie devenant asservie en phase à celui-ci.

2. Circuit de commande automatique de fréquence selon la revendication 1 comprenant :
ledit circuit de détection (72) étant sensible à la présence d'un signal FI alors que la boucle verrouillée en phase est dans un état déverrouillé pour fournir un signal de validation supplémentaire ;
un circuit de balayage (78) sensible audit signal de validation supplémentaire appliqué à celui-ci à partir dudit circuit de détection pour fournir un signal de commande de balayage au VCO qui entraîne la fréquence du VCO à balayer d'abord vers le bas à partir de ladite fréquence prédéterminée jusqu'à une autre fréquence prédéterminée ensuite à balayer vers le haut jusqu'à ladite fréquence de fonctionnement nominale ; et
ledit circuit de balayage étant sensible audit VCO devenant asservi en phase sur le signal FI pour invalider ledit circuit de décalage, ledit circuit de balayage et ledit circuit de verrouillage.

3. Circuit de commande automatique de fréquence selon la revendication 2 dans lequel ledit circuit de détection (72) fournit un signal d'invalidation au détecteur de phase (18) pendant le temps pendant lequel le VCO balaye vers le bas en fréquence à l'aide dudit circuit de balayage.

4. Circuit de récepteur de télévision comprenant le circuit de commande automatique de fréquence selon la revendication 1, 2 ou 3 et une partie de démodulateur comprenant :
des premier (14) et second (16) étages limiteurs en cascade pour limiter l'amplitude d'un signal d'entrée appliqué audit premier étage limiteur ;
la boucle de phase asservie (PLL) (20), qui est couplée à la sortie dudit second étage limiteur, comprend l'oscillateur commandé en tension (VCO) (24) activé à la moitié de la fréquence du signal d'entrée, et des troisième (30) et quatrième (32) étages limiteurs en cascade ;
un circuit de décalage (34) recevant le signal d'entrée pour fournir une valeur prédéterminée de déphasage à celui-ci ; et
le circuit démodulateur (36) recevant à la fois ledit signal d'entrée déphasé et un signal de sortie dudit PLL pour démoduler le signal d'entrée pour fournir un signal de sortie détecté.

5. Circuit récepteur de télévision selon la revendication 4 comprenant un circuit de rétroaction à courant continu (DC) (40) couplé entre la sortie dudit second étage limiteur et l'entrée dudit premier étage limiteur.

6. Circuit récepteur de télévision selon la revendication 5 dans lequel ledit PLL comprend :
un circuit détecteur de phase (18) couplé à ladite sortie dudit second étage limiteur (16) et la sortie dudit quatrième étage limiteur (32) pour fournir un signal d'erreur lorsque le signal d'entrée limité est autrement qu'en quadrature de phase par rapport au signal VCO ;
un filtre passe-bas (22) couplé entre ledit dispositif détecteur de phase et ledit VCO ; et
un circuit multiplieur (28) couplé entre la sortie dudit VCO et l'entrée du troisième étage limiteur (30) pour doubler la fréquence dudit signal VCO pour fournir ledit signal de sortie dudit PLL (20).

7. Circuit récepteur de télévision selon la revendication 5 dans lequel ledit circuit de rétroaction à courant continu (DC) comprend :
des première (42) et seconde (44) résistances en série couplées entre une première sortie dudit second étage limiteur (16) et une première entrée dudit premier étage limiteur (14) ;
des troisième (46) et quatrième (48) résistances en série couplées entre une seconde sortie dudit seconde étage limiteur et une seconde entrée dudit premier étage limiteur ; et
un condensateur (50) couplé entre les interconnexions desdites première et seconde résistances et desdites troisième et quatrième résistances.

8. Circuit récepteur de télévision selon les revendications 4, 5, 6, ou 7 dans lequel le circuit de déphasage (34) comprend :
un premier amplificateur différentiel comprenant des premier (164) et second (172) transistors, la base dudit second transistor étant polarisée à un potentiel de référence ;
un second amplificateur différentiel comprenant des troisième (166) et quatrième (178) transistors, la base dudit quatrième transistor étant polarisée audit potentiel de référence, les bases desdits premier et troisième transistors étant couplées à une paire d'entrées du circuit de déphasage auquel une tension d'entrée différentielle est appliquée ;
un premier condensateur (174) couplé entre les émetteurs desdits premier et second transistors ;
un second condensateur (176) couplé entre les émetteurs desdites troisième et quatrième transistors ;
une première résistance (188) couplée entre lesdits émetteurs desdits second et quatrième transistors ;
une seconde résistance (186) couplée entre lesdits émetteurs desdits premier et troisième transistors ; et
les collecteurs desdits second et quatrième transistors étant couplés à une charge (184).
